(19) Europäisches Patentamt
European Patent Office
Office européen des brevets

(11) **EP 3 060 957 B1**

(12) **FASCICULE DE BREVET EUROPEEN**

(45) Date de publication et mention
de la délivrance du brevet:
**13.12.2017 Bulletin 2017/50**

(51) Int Cl.:
**G02B 27/09** (2006.01)  **H01S 3/00** (2006.01)
**B23K 26/06** (2014.01)  **H01S 5/40** (2006.01)

(21) Numéro de dépôt: **14796824.2**

(22) Date de dépôt: **16.10.2014**

(86) Numéro de dépôt international:
**PCT/FR2014/052642**

(87) Numéro de publication internationale:
**WO 2015/059388 (30.04.2015 Gazette 2015/17)**

(54) **APPAREIL LASER MODULAIRE**

MODULARES LASERGERÄT

MODULAR LASER DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.10.2013 FR 1360222**

(43) Date de publication de la demande:
**31.08.2016 Bulletin 2016/35**

(73) Titulaire: **Saint-Gobain Glass France
92400 Courbevoie (FR)**

(72) Inventeurs:
• **DUBOST, Brice
Newton, MA 02459 (US)**

• **MIMOUN, Emmanuel
F-92100 Boulogne-Billancourt (FR)**
• **SCHWEITZER, Jean-Philippe
F-60300 Chamant (FR)**

(74) Mandataire: **Saint-Gobain Recherche
Département Propriété Industrielle
39 Quai Lucien Lefranc
93300 Aubervilliers (FR)**

(56) Documents cités:
**WO-A1-2007/122061**  **WO-A2-2008/024211**
**JP-A- S5 737 325**  **JP-A- 2002 268 001**
**JP-A- 2005 221 872**  **US-A- 5 665 985**
**US-A1- 2012 281 293**

**Description**

La présente invention concerne un appareil pour le recuit laser de substrats de grande largeur formé d'une pluralité de modules laser juxtaposables sans limitation particulière.

Il est connu d'effectuer un recuit laser local et rapide (*laser flash heating*) de revêtements déposés sur des substrats plats. Pour cela on fait défiler le substrat avec le revêtement à recuire sous une ligne laser, ou bien une ligne laser au-dessus du substrat portant le revêtement.

Le recuit laser permet de chauffer des revêtements minces à des températures élevées, de l'ordre de plusieurs centaines de degrés, tout en préservant le substrat sous-jacent. Les vitesses de défilement sont bien entendu de préférence les plus élevées possibles, avantageusement au moins de plusieurs mètres par minute.

La présente invention s'intéresse en particulier aux lasers utilisant des diodes laser. Celles-ci constituent actuellement les sources laser les plus intéressantes du point de vue de leur prix et de leur puissance.

Afin d'obtenir les puissances linéiques nécessaires à la mise en oeuvre d'un procédé avec une vitesse de défilement élevée, il est souhaitable de concentrer le rayonnement d'un très grand nombre de diodes laser au niveau d'une ligne laser unique. Au niveau du substrat portant le revêtement à recuire la densité de puissance de cette ligne laser doit généralement être la plus uniforme possible, de manière à exposer tous les points du substrat à une même énergie de recuit.

Il serait par ailleurs souhaitable de pouvoir traiter à grande vitesse des substrats de grande largeur, tels que les feuilles de verre plat de taille « jumbo » (6 m x 3,21 m) sortant des procédés de *float.* La problématique pour l'obtention de très longues lignes laser est la réalisation d'un système de juxtaposition de modules laser permettant l'allongement à volonté de la longueur de la ligne, sans avoir à fabriquer des optiques monolithiques aussi longues que la ligne elle-même.

Des appareils laser modulaires ont déjà été envisagés. Ainsi, le brevet US 6 717 105 décrit un appareil laser modulaire de conception très simple. Dans cet appareil laser chaque module (oscillateur laser 1a,1b,1c) génère un faisceau laser qui, après mise en forme, est réfléchi par un miroir (4a,4b,4c) et projeté, sous forme d'une ligne laser, avec un angle droit sur le substrat (5). Les moyens de mise en forme (3a,3b,3c) du faisceau laser sont conçus de manière à former au niveau de l'intersection avec le substrat une ligne laser présentant un profil de densité de puissance ayant la forme d'un « chapeau claque » (en anglais *top-hat*) avec une partie centrale très étendue où la densité de puissance est forte et constante et, de part et d'autre de ce plateau, des flancs descendant en pente raide (voir figure 5 de US 6 717 105). Les profils sont combinés par superposition des flancs pentus de manière à créer une ligne unique combinée avec une répartition de densité de puissance la plus uniforme possible.

Des modules laser générant ce type de ligne laser à profil « chapeau claque » sont toutefois très sensibles à d'éventuelles erreurs de positionnement des modules les uns par rapport aux autres. En effet, la grande raideur des pentes au niveau des zones latérales superposées fait qu'un écartement trop important des modules aboutit facilement à un défaut de densité de puissance au niveau de la jonction et, à l'inverse, des modules trop rapprochés aboutiraient à des zones de jonction où la densité de puissance est excessivement élevée.

La Demanderesse a constaté qu'il est possible de réduire significativement la sensibilité d'un appareil laser modulaire à une erreur de positionnement respectif des modules laser en munissant les modules de l'appareil d'un système optique de mise en forme de la ligne laser à base de microlentilles qui crée non pas un profil de densité de puissance de type « chapeau claque », généralement recherché dans l'état de la technique, mais un profil de type « chapeau pointu », c'est-à-dire un profile qui s'approche d'un triangle, avec une pente régulière décroissante du centre vers les extrémités.

WO 2007122061 divulgue un appareil laser avec deux modules laser générant chacun une ligne laser au niveau d'un plan de travail. Un module comprend un émetteur laser, premier et deuxième alignements de microlentilles convergents dans une direction et une lentille convergente dans la direction orthogonal. Les profiles de densité de puissance émises d'un module se superposent dans le plan de travail. Toutes ces profiles des modules laser sont juxtaposés dans le plan der travail. La présente invention a pour objet un appareil laser comme celui définit dans la revendication 1. Contrairement à l'état de la technique, on ne cherche donc pas dans la présente invention à fabriquer des modules laser qui émettent chacun une ligne laser avec un profil de densité de puissance comportant un plateau de puissance utile le plus large possible. On cherche au contraire à réduire l'étendue de la zone centrale de forte puissance ($L_{90}$) à moins de 20 %, de préférence à moins de 15 % et en particulier à moins de 10 % de la longueur totale de la ligne laser du module, et également à réduire la valeur de la pente de part et d'autre de la zone de puissance maximale. En effet, plus la pente des deux flancs du profil de densité de puissance émis par chaque module sera faible, moins une erreur de positionnement des modules se répercutera sur le profil de densité de puissance combiné formé par l'alignement de modules. La forme idéale du profile de puissance d'une ligne générée par chaque module est par conséquent le triangle présentant une hauteur (*h*) égale à la puissance maximale et une base (*b*) égale à la longueur de la ligne laser.

Idéalement la pente des flancs du profil de densité de puissance est donc égale à celle de ce triangle (2h/b).

Le profil réel de densité de puissance peut toutefois s'écarter faiblement de la forme triangulaire stricte.

De préférence, la ligne laser finale générée par chaque module laser présente, au niveau du plan de travail, un profil de densité de puissance avec un maximum de densité de puissance situé au centre de la ligne laser et une décroissance régulière de la densité de puissance depuis le centre vers les extrémités de la ligne, la pente de la décroissance s'écartant d'au plus 20 %, de préférence d'au plus 10 %, de la pente d'un profil parfaitement triangulaire de mêmes $L_{10}$ et $L_{90}$. Le terme « pente de la décroissance » désigne ici la pente moyenne observée sur une longueur égale à un 1/50 de la longueur de la ligne laser.

Les modules laser sont juxtaposés de manière à ce que le profil de densité de puissance de la ligne laser combinée, résultant de la somme de l'ensemble des profils de densité de puissance individuels, soit un profil en forme de chapeau claque (top-hat) avec une zone centrale représentant au moins 90 % de la longueur totale de la ligne laser combinée de l'appareil où la densité de puissance varie d'au plus 10 %, de préférence d'au plus 5 % et de manière particulièrement avantageuse d'au plus 1 %.

La faible largeur de la zone de puissance utile ($L_{90}$) des profils triangulaires de chaque module est compensée dans l'appareil de la présente invention par un très large recouvrement des lignes lasers individuelles générées par deux modules adjacents.

En effet, pour arriver à produire un profil combiné de type chapeau claque à partir de profils individuels triangulaires de type « chapeau pointu », il est indispensable que la presque totalité des points du profil final résulte de l'addition d'au moins deux profils individuels qui se recouvrent partiellement.

Dans un mode de réalisation préféré de la présente invention, les modules laser sont juxtaposés de telle manière que chaque extrémité d'une ligne laser générée par un module laser est située à proximité immédiate du centre de la ligne laser générée par le module adjacent. Ainsi, dans la partie centrale du profil combiné où la densité de puissance est constante, chaque point de la ligne laser fait de préférence partie de deux profils laser triangulaires générés respectivement par deux modules laser différents voisins l'un de l'autre.

Cette manière de combiner des profils est très différente de celle de l'état de la technique où l'on cherche généralement à générer et combiner plusieurs profils individuels de type « chapeau claque », et où les zones de recouvrement des profils individuels ne représentent normalement pas plus de quelques pourcents de la longueur totale de la ligne laser.

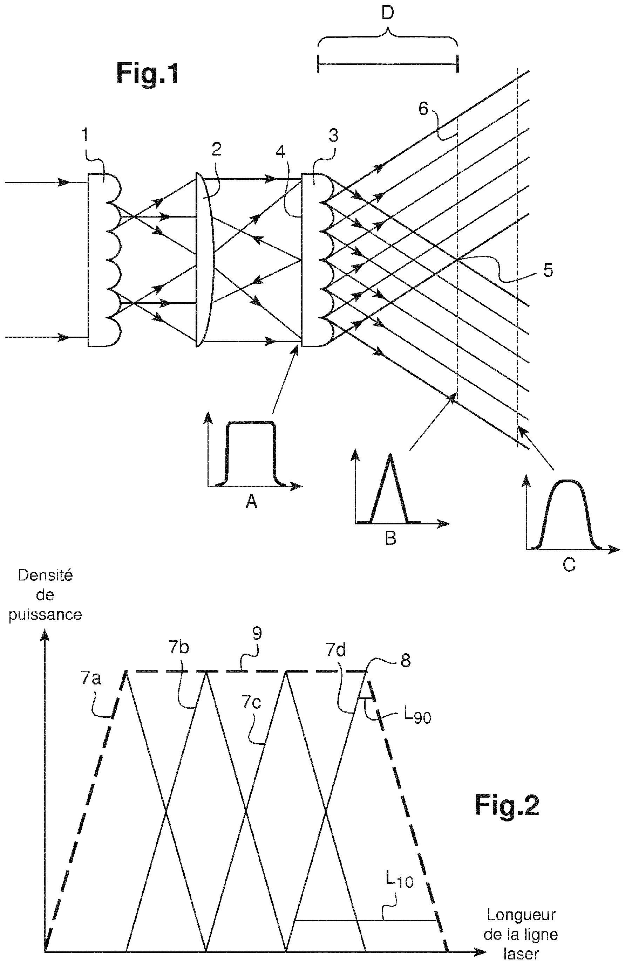

Dans un mode de réalisation de l'appareil de la présente invention où n modules, générant chacun une ligne laser de longueur $L_i$ avec un profil de densité de puissance de forme sensiblement triangulaire, sont juxtaposés de manière à former une ligne unique de type « chapeau claque » (voir figure 2) la longueur globale ($L_g$) de cette ligne unique est égale à

$$L_g = (n+1) \times 0{,}5 \, L_i.$$

La longueur globale $L_g$ est donc de préférence égale à un multiple de la demi-longueur de de la ligne laser générée par chaque module individuellement.

On connait dans l'état de la technique des systèmes de lentilles permettant de conférer à des lignes laser un profil de densité de puissance de type chapeau claque. Un tel système est décrit par exemple dans la demande US 2012/0127723. Il comporte un premier réseau de microlentilles (4) combiné à des lentilles convergentes (5) de plus grande taille recevant chacune la lumière de plusieurs microlentilles. Au plan focal (8) chaque lentille convergente crée un profil de densité de puissance (9) en forme de chapeau claque avec une partie centrale relativement large et des flancs décroissants (10) ayant une pente relativement raide.

Dans la présente invention, l'ensemble de microlentilles permettant d'obtenir une ligne laser à profil triangulaire est placé dans le plan focal d'une lentille convergente formant un profil de densité de puissance de type chapeau claque. L'ensemble de microlentilles comprend un alignement de N microlentilles cylindriques d'une distance focale D.

Comme il sera expliqué ci-après en référence à la figure 1, le profil de densité de puissance de la ligne laser mis en forme par cet alignement de microlentilles varie avec la distance par rapport à l'ensemble de microlentilles. A proximité immédiate de l'alignement de microlentilles il est de type chapeau claque. Sa forme devient de plus en plus triangulaire au fur et à mesure qu'on s'éloigne de l'alignement.

La distance (D) exacte à laquelle il a la forme d'un triangle peut être calculée, de manière connue, grâce à la formule suivante :

$$D = N \times F$$

où

N désigne le nombre de microlentilles, et
F désigne la distance focale de chaque microlentille, à condition que la dimension de l'ensemble de microlentilles soit négligeable par rapport à la distance entre l'ensemble de microlentilles et la lentille convergente formant le profil de densité de puissance chapeau claque.

On placera avantageusement le plan de travail (substrat) à une distance égale à $D \pm 15\%$, de préférence à $D \pm 5\%$, et idéalement précisément à une distance D par rapport à l'alignement de microlentilles.

Il est bien entendu possible et facile pour l'homme du métier de choisir, grâce à la formule ci-dessus, un alignement de microlentilles approprié pour obtenir un profil de densité de puissance triangulaire à une distance D imposée.

L'appareil laser modulaire de la présente invention comprend de préférence au moins 5 modules, en particulier au moins 10 modules.

Les modules laser sont avantageusement juxtaposés de manière à ce que les lignes laser générées se combinent en une ligne laser unique d'une longueur totale supérieure à 1,2 m, de préférence supérieure à 2 m, en particulier supérieure à 3 m.

Dans la perspective du traitement laser de substrats de type « jumbo » ayant une largeur de 3,21 m, la partie centrale de la ligne laser où la densité de puissance est sensiblement constante, a de préférence une longueur comprise entre 3,20 et 3,22 m.

Par ailleurs, les modules lasers sont assemblés et montés sur l'appareil laser de manière à ce que les lignes laser générées coupent le substrat, ou plan de travail, de préférence à un petit angle, typiquement inférieur à 20 °, de préférence inférieur à 10 ° par rapport à la normale au substrat. L'appareil peut être conçu de manière à ce que les modules laser soient fixes, le substrat à traiter défilant en-dessous ou au-dessus de l'alignement de modules, généralement dans une direction perpendiculaire à l'axe principal de la ligne laser. En variante, l'appareil peut être conçu de manière à ce que le substrat soit fixe et l'alignement de modules laser défile au-dessus ou en-dessous du substrat en y projetant la ligne laser.

L'invention sera à présent décrite en référence aux figures annexées dans lesquelles

la figure 1 est un schéma explicatif représentant un système optique permettant l'obtention d'une ligne laser présentant un profil de densité de puissance de forme triangulaire, et

la figure 2 est un schéma explicatif montrant la manière de combiner plusieurs profils de densité de puissance de forme triangulaire pour obtenir un profil combiné de type chapeau claque.

Sur la figure 1 la combinaison d'un alignement de microlentilles 1 et d'une lentille convergente 2 aboutit, au plan de focalisation 4 de cette dernière, à une ligne laser présentant un profil de densité de puissance de type chapeau claque A. Un deuxième alignement de microlentilles 3 est placé précisément au plan de focalisation 4 de la lentille convergente 2. Chacune des microlentilles de l'alignement 3 produit un faisceau d'abord convergent, puis divergent au-delà du point de focalisation. Les faisceaux des deux microlentilles situées aux extrémités de l'alignement de microlentilles se croisent au point 5. Ce point de croisement 5 des deux faisceaux les plus à l'extérieur de la ligne laser est situé sur la droite 6, parallèle à l'alignement de microlentilles 3, où le profil de densité de puissance de la ligne laser aura le profil triangulaire B. Cette droite 6 est à une distance D par rapport à l'alignement de microlentilles 3. Le substrat à traiter (non représenté) devra être placé de manière à ce que la droite 6 soit située dans le plan de celui-ci. A une distance D' supérieure à D, l'allure du profil de densité de puissance C s'approchera de nouveau de celle d'un chapeau claque.

Le moyen de mise en forme de la ligne laser comportant un premier alignement de microlentilles 1, une lentille convergente 2 et un deuxième alignement de microlentilles 3 placé dans la plan de focalisation de la lentille convergente 2, protège le système contre un défaut d'homogénéité d'intensité d'irradiation en cas de défaillance d'une ou plusieurs sources laser individuelles placées derrière une ou plusieurs des microlentilles de l'alignement de microlentilles 1. En effet la lumière provenant de l'ensemble des sources laser d'un module est mélangée dans la lentille convergente 2 puis mise en forme par l'ensemble de microlentilles 3. La défaillance d'une diode laser placée derrière une microlentille du premier alignement de microlentilles aboutira une réduction de la puissance de la ligne laser, mais non pas à un défaut d'homogénéité de l'intensité.

La figure 2 montre les profils de densité de puissance 1a, 1b, 1c, 1d de quatre lignes laser générées par quatre modules (non représentés) juxtaposés conformément à la présente invention. Les quatre profils sont de forme identique. Chaque profil présente un maximum de densité de puissance 2, une largeur à 90 % de la densité de puissance maximale $L_{90}$, une largeur à 10 % de la densité de puissance maximale $L_{10}$. Le profil 3 en pointillés correspond au profil de densité de puissance résultant de l'addition des profils triangulaires individuels. Ce profil a une allure de type chapeau claque. Les modules laser (non représentés) sont placés de manière à ce que, dans la partie plateau du profil global 3, chacun des points du profil résulte de l'addition des profils de deux modules laser voisins.

**Revendications**

1. Appareil laser comprenant plusieurs modules laser générant chacun une ligne laser au niveau d'un plan de travail, chacun des modules laser comprenant

   - au moins un moyen de génération d'une ligne laser, et
   - un moyen de mise en forme de la ligne laser,

   ledit moyen de mise en forme de la ligne laser comportant un premier alignement de microlentilles (1), une lentille convergente (2) et un deuxième alignement de microlentilles (3) placé dans le plan de focalisation (4) de la lentille convergente (2), tel que la ligne laser finale générée par chaque module laser présente, au niveau du plan de travail, un profil de densité de puissance avec une largeur à 90 % de la densité de puissance maximale ($L_{90}$) et une largeur à 10 % de la densité de puissance maximale ($L_{10}$),

le rapport $L_{90}/L_{10}$ étant compris entre 1/15 et 1/5, les modules laser étant juxtaposés de manière à ce que les lignes laser générées par les modules se combinent au niveau dudit plan de travail, en une ligne laser unique d'une longueur totale supérieure à 1,2 m.

2. Appareil laser selon la revendication 1, **caractérisé par le fait que** le rapport $L_{90}/L_{10}$ est compris entre 1/12 et 1/7, de préférence entre 1/10 et 1/8.

3. Appareil laser selon la revendication 1 ou 2, **caractérisé par le fait que** la ligne laser finale générée par chaque module laser présente, au niveau du plan de travail, un profil de densité de puissance avec un maximum de densité de puissance situé au centre de la ligne laser et une décroissance de la densité de puissance depuis le centre vers les extrémités de la ligne, la pente de la décroissance s'écartant d'au plus 20 %, de préférence d'au plus 10 %, de la pente d'un profil parfaitement triangulaire de mêmes $L_{10}$ et $L_{90}$.

4. Appareil laser selon l'une quelconque des revendications précédentes, **caractérisé par le fait que** les modules laser sont juxtaposés de manière à ce que le profil de densité de puissance de la ligne laser combinée, résultant de la somme de l'ensemble des profils de densité de puissance individuels, est un profil en forme de chapeau claque avec une zone centrale représentant au moins 90 % de la longueur totale de la ligne laser combinée de l'appareil où la densité de puissance varie d'au plus 10 %, de préférence d'au plus 5 % et de manière particulièrement avantageuse d'au plus 1 %.

5. Appareil laser selon l'une quelconque des revendications précédentes, **caractérisé par le fait que** les modules laser sont juxtaposés de telle manière que chaque extrémité d'une ligne laser générée par un module laser est située à proximité immédiate du centre de la ligne laser générée par le module adjacent.

6. Appareil laser selon l'une quelconque des revendications précédentes, **caractérisé par le fait qu'**il comprend au moins 5 modules, de préférence au moins 10 modules.

7. Appareil laser selon l'une quelconque des revendications précédentes, **caractérisé par le fait que** les modules laser sont juxtaposés de manière à ce que les lignes laser générées par les modules se combinent en une ligne laser unique d'une longueur totale supérieure à 2 m, en particulier supérieure à 3 m.

**Patentansprüche**

1. Lasergerät, umfassend mehrere Lasermodule, von denen jedes eine Laserlinie im Bereich einer Arbeitsebene erzeugt, wobei jedes der Lasermodule umfasst

   - mindestens ein Erzeugungsmittel einer Laserlinie, und
   - ein Formgebungsmittel der Laserlinie, wobei das Formgebungsmittel der Laserlinie aufweist

   eine erste Mikrolinsenjustierung (1), eine konvergierende Linse (2) und eine zweite Mikrolinsenjustierung (3), die in der Fokussierungsebene (4) der konvergierenden Linse (2) derart platziert ist, dass die von jedem Lasermodul erzeugte fertige Laserlinie im Bereich der Arbeitsebene ein Leistungsdichteprofil mit einer Breite bei 90 % der maximalen Leistungsdichte ($L_{90}$) und einer Breite bei 10 % der maximalen Leistungsdichte ($L_{10}$) aufweist, wobei das Verhältnis $L_{90}/L_{10}$ von 1/15 bis 1/5 ist, wobei die Lasermodule derart nebeneinanderliegen, dass sich die von den Modulen erzeugten Laserlinien im Bereich der Arbeitsebene zu einer einzigen Laserlinie mit einer Gesamtbreite über 1,2 m verbinden.

2. Lasergerät nach Anspruch 1, **dadurch gekennzeichnet, dass** das Verhältnis $L_{90}/L_{10}$ von 1/12 bis 1/7, vorzugsweise von 1/10 bis 1/8, beträgt.

3. Lasergerät nach Anspruch 1 oder 2, **dadurch gekennzeichnet, dass** die von jedem Lasermodul erzeugte fertige Laserlinie im Bereich der Arbeitsebene ein Leistungsdichteprofil mit einem Leistungsdichtemaximum, das sich im Zentrum der Laserlinie befindet, und einer abfallenden Leistungsdichte ab dem Zentrum zu den Enden der Linie aufweist, wobei sich die Abfallneigung höchstens um 20 %, vorzugsweise höchstens um 10 %, von der Neigung eines perfekt dreieckigen Profils derselben $L_{10}$ und $L_{90}$ unterscheidet.

4. Lasergerät nach einem der vorangehenden Ansprüche, **dadurch gekennzeichnet, dass** die Lasermodule derart nebeneinanderliegen, dass das Leistungsdichteprofil der verbundenen Laserlinie im Ergebnis der Summe der Gesamtheit der individuellen Leistungsdichteprofile ein Profil in Chapeau claque-Form mit einer zentralen Zone ist, die mindestens 90 % der Länge insgesamt der verbundenen Laserlinie des Geräts aufweist, wobei die Leistungsdichte höchstens um 10 %, vorzugsweise höchstens um 5 % und in besonders vorteilhafter Weise höchstens um 1 % schwankt.

5. Lasergerät nach einem der vorangehenden Ansprüche, **dadurch gekennzeichnet, dass** die Lasermodule derart nebeneinanderliegen, dass sich jedes Ende einer von einem Lasermodul erzeugten Laserlinie in unmittelbarer Nähe des Zentrums der von dem benachbarten Modul erzeugten Laserlinie befindet.

**6.** Lasergerät nach einem der vorangehenden Ansprüche, **dadurch gekennzeichnet, dass** es mindestens 5 Module, vorzugsweise mindestens 10 Module, umfasst.

**7.** Lasergerät nach einem der vorangehenden Ansprüche, **dadurch gekennzeichnet, dass** Lasermodule derart nebeneinanderliegen, dass sich die von den Modulen erzeugten Laserlinien in einer einzigen Laserlinie mit einer Länge insgesamt über 2 m, insbesondere über 3 m, vereinen.

**Claims**

**1.** A laser apparatus comprising a plurality of laser modules each generating a laser line in a working plane, each of the laser modules comprising:

- at least one means for generating a laser line; and
- a means for shaping the laser line,

the means for shaping the laser line comprising a first linear array (1) of microlenses, a convergent lens (2) and a second linear array (3) of microlenses placed in the focal plane (4) of the convergent lens (2), such that the final laser line generated by each laser module has, in the working plane, a power density profile with a width ($L_{90}$) at 90% of the maximum power density and a width ($L_{10}$) at 10% of the maximum power density, the ratio $L_{90}/L_{10}$ being comprised between 1/15 and 1/5, the laser modules being juxtaposed so that the laser lines generated by the modules combine, in the working plane, into a single laser line having a total length longer than 1.2 m.

**2.** The laser apparatus as claimed in claim 1, **characterized in that** the ratio $L_{90}/L_{10}$ is comprised between 1/12 and 1/7 and preferably between 1/10 and 1/8.

**3.** The laser apparatus as claimed in either of claims 1 and 2, **characterized in that** the final laser line generated by each laser module has, in the working plane, a power density profile with a maximum power density at the centre of the laser line, the power density decreasing from the centre to the ends of the line, the slope of the decrease differing by at most 20% and preferably by most 10% from the slope of a perfectly triangular profile of same $L_{10}$ and $L_{90}$.

**4.** The laser apparatus as claimed in any one of the preceding claims, **characterized in that** the laser modules are juxtaposed so that the power density profile of the combined laser line, resulting from the sum of all the individual power density profiles, is a top-hat profile having a central zone representing at least 90% of the total length of the combined laser line of the apparatus, in which zone the power density varies by at most 10%, preferably by at most 5% and particularly advantageously by at most 1%.

**5.** The laser apparatus as claimed in any one of the preceding claims, **characterized in that** the laser modules are juxtaposed in such a way that each end of a laser line generated by a laser module is located in the immediate proximity of the centre of the laser line generated by the adjacent module.

**6.** The laser apparatus as claimed in any one of the preceding claims, **characterized in that** it comprises at least 5 modules and preferably at least 10 modules.

**7.** The laser apparatus has claimed in any one of the preceding claims, **characterized in that** the laser modules are juxtaposed so that the laser lines generated by the modules combine into a single laser line having a total length longer than 2 m and in particular longer than 3 m.

Fig.1

D

6

1

2    4    3

5

A

B

C

Densité
de
puissance

7b        9        7d

7a              7c        8

L₉₀

L₁₀

Longueur
de la ligne
laser

Fig.2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6717105 B
- WO 2007122061 A
- US 20120127723 A